# EUROPÄISCHE PATENTANMELDUNG

(11) **EP 4 831 651 A1**
(43) Veröffentlichungstag der Anmeldung: **28.10.2026**
(21) Anmeldenummer: 26170530.5
(22) Anmeldetag: 02.04.2026
(51) Int. Cl.: G01R 15/12, G01R 15/14, G01R 15/18

(54) **ELEKTRONISCHES MESSGERÄT ZUR MESSUNG ELEKTRISCHER GRÖSSEN**

(30) Priorität: 25.04.2025 DE 102025116051
(71) Anmelder: Robert Bosch GmbH, 70442 Stuttgart (DE)
(72) Erfinder: Chan, Chi Fung, 73760 Ostfildern (DE); YING, Jianbang, Hangzhou, Zhejiang, 311400 (CN); Zhang, Xinhui, Hangzhou, 311400 (CN); Burman, Kunal Shyamadas, 70771 Echterdingen (DE); Kohlert, Thomas, 29780 Nerja (ES)

(57) **Zusammenfassung**

Die Erfindung bezieht sich auf ein elektronisches Messgerät (10) zur Messung elektrischer Größen, insbesondere von Spannung, Strom und/oder elektrischem Widerstand. Das elektronische Messgerät (10) umfasst ein Gehäuse (12), in dem ein Batteriefach (22) zur Aufnahme einer Energiequelle (26) ausgebildet ist, welches über einen entnehmbaren Batteriefachdeckel (24) zugänglich ist. Das Batteriefach (22) ist mit einem Trennschalter (34) versehen, der bei Entnahme des Batteriefachdeckels (24) vom Batteriefach (22) das gesamte elektronische Messgerät (10) oder zumindest dessen Bedienelemente (18, 20) abschaltet.

## Beschreibung

### Technisches Gebiet

Die Erfindung bezieht sich auf ein elektronisches Messgerät zur Messung elektrischer Größen, insbesondere Spannung, Strom und/oder elektrische Widerstände, mit einem Gehäuse, in dem ein Batteriefach zur Aufnahme einer Stromquelle ausgebildet ist, welches über einen entnehmbaren Batteriefachdeckel zugänglich ist.

### Stand der Technik

CN 220086290 U hat eine Batterieabdeckung zum Gegenstand sowie ein Multimeter mit einer solchen Batterieabdeckung. Eine obere Batterieabdeckung wird während des Aufladens entfernt. Sie dient ansonsten der Vermeidung elektrischer Schläge, Ölflecken, Staub, Wasserflecken und dergleichen.

DE 10 2008 036 823 A1 offenbart eine Gehäusestruktur mit einem Gehäuse und ein entsprechendes Multimeter. Das Gehäuse besitzt eine Schale aus steifem Polymermaterial, welches wenigstens eine, ein weicheres Polymermaterial enthaltende Nute definiert. Zusätzlich umfasst die Gehäusestruktur wenigstens ein steifes Plattenelement, welches an dem Gehäuse anliegt. Hierbei wird unter anderem ein Ansatz für eine Dichtungsanordnung zwischen dem Batteriefach und dem Batteriefachdeckel offenbart, um das Eindringen von Feuchtigkeit und anderen Verunreinigungen zu verhindern.

DE 10 2005 036 037 A1 betrifft ein Messgerät, insbesondere ein elektrooptisches Entfernungsmessgerät. Es wird eine Gehäuseabdichtung offenbart, für die ein vorzugsweise elastischer Werkstoff sowohl das Gehäuse, das aus einem anderen Werkstoff besteht, zumindest teilweise umgreift als auch eine Öffnung, wie insbesondere ein Batteriefach, gegenüber dem Gehäuseinnenraum abdichtet. Dadurch kann auf zusätzliche Dichtstoffe oder Dichtelemente im Wesentlichen verzichtet werden.

### Offenbarung der Erfindung

Erfindungsgemäß wird ein elektronisches Messgerät zur Messung elektrischer Größen, insbesondere Spannung, Strom und/oder elektrische Widerstände, vorgeschlagen, welches ein Gehäuse umfasst, in dem ein Batteriefach zur Aufnahme einer Energiequelle ausgebildet ist, welches durch einen entnehmbaren Batteriefachdeckel zugänglich ist. Das Batteriefach ist mit einem Trennschalter versehen, der bei Entnahme des Batteriefachdeckels vom Batteriefach das gesamte elektronische Messgerät oder zumindest dessen Bedienelemente abschaltet.

Durch die erfindungsgemäß vorgeschlagene Lösung kann in vorteilhafter Weise erreicht werden, dass Benutzer des manuell handhabbaren elektronischen Messgeräts vor Stromschlägen geschützt sind.

In vorteilhafter Weiterbildung des erfindungsgemäß vorgeschlagenen elektronischen Messgeräts ist vorgesehen, dass der Batteriefachdeckel an einer Innenseite ein Betätigungselement aufweist, welches im auf dem Batteriefach montierten Zustand des Batteriefachdeckels den Trennschalter betätigt.

Dadurch ist sichergestellt, dass im montierten Zustand des Batteriefachdeckels eine einwandfreie Strom- beziehungsweise Spannungsversorgung des erfindungsgemäß vorgeschlagenen elektronischen Messgeräts sichergestellt ist.

In vorteilhafter Weiterbildung des erfindungsgemäß vorgeschlagenen elektronischen Messgerätes ist vorgesehen, dass der Trennschalter in das Gehäuse, insbesondere in einen Boden des Batteriefachs eingelassen ist.

In einer vorteilhaften Weiterbildung des elektronischen Messgerätes weist der Trennschalter einen einseitig an dessen Schalterkörper angelenkten Schaltarm auf. Bei Montage des das Betätigungselement aufweisenden Batteriefachdeckels wird dieser Schaltarm durch das Betätigungselement ausgelenkt und berührt einen am Schaltkörper des Trennschalters vorgesehenen Kontakt zur Freigabe der Strom- beziehungsweise Spannungsversorgung am elektronischen Messgerät.

In vorteilhafter Weiterbildung des elektronischen Messgeräts ist vorgesehen, dass der Trennschalter auf einer Oberseite einer Leiterplattenanordnung aufgenommen ist. Des Weiteren ist beim erfindungsgemäß vorgeschlagenen elektronischen Messgerät vorgesehen, dass die Leiterplattenanordnung im Innenraum des Gehäuses im Wesentlichen auf dem Niveau des Bodens des Batteriefachs liegt und mittels einer Anstellfeder an eine Gehäuserippe oder einen Gehäusevorsprung im Inneren des Gehäuses angestellt ist.

Das erfindungsgemäß vorgeschlagene elektronische Messgerät zeichnet sich ferner dadurch aus, dass bei montiertem Batteriefachdeckel dessen Betätigungselement den Schaltarm des Trennschalters an eine Kontaktstelle des Schalterköpers anstellt und die Strom- beziehungsweise Spannungsversorgung des elektronischen Messgerätes sowie von dessen Bedienelementen freigibt.

Des Weiteren ist beim erfindungsgemäß vorgeschlagenen elektronischen Messgerät vorgesehen, dass das Betätigungselement an der Innenseite des Batteriefachdeckels im Wesentlichen stab- oder stiftförmig ausgeführt ist.

In einer vorteilhaften Ausführungsvariante des elektronischen Messgeräts ist das Betätigungselement als federnder Kontaktstift ausgeführt.

Darüber hinaus ist beim erfindungsgemäß vorgeschlagenen elektronischen Messgerät vorgesehen, dass die Stromquelle entweder als wiederaufladbarer Lithium-lonen-Akkumulator oder als mindestens eine Alkaline-Batterie ausgeführt ist.

Das erfindungsgemäß vorgeschlagene elektronische Messgerät kann als Multimeter, als Zangenamperemeter, als Gabelamperemeter oder als Spannungsmessgerät ausgeführt sein, zur Messung elektrischer Größen, insbesondere von Strömen, Spannungen, elektrischen Widerständen, Kapazitäten, Temperaturen oder Impedanzen, in Gleichstrom- oder Wechselstromanwendungen.

### Vorteile der Erfindung

Durch die erfindungsgemäß vorgeschlagene Lösung ist sichergestellt, dass im montierten Zustand des Batteriefachdeckels auf dem Batteriefach der im Boden des Batteriefachs innerhalb des Gehäuses angeordnete Trennschalter betätigt wird und somit eine Spannungs- beziehungsweise Stromversorgung des elektronischen Messgerätes sowie von dessen Bedienelementen, beispielsweise Display oder verdrehbarer Wahlschalter oder dergleichen, sichergestellt ist. Sobald jedoch der Batteriefachdeckel dem Batteriefach entnommen wird, verlässt der stab- oder stiftförmige oder als federnder Kontaktstift ausgebildete Vorsprung beziehungsweise das Betätigungselement an der Innenseite des Batteriefachdeckels den Trennschalter. Der Trennschalter kann auch als magnetischer Schalter oder magnetischer Sensor zur Abschaltung des Gerätes bei geöffnetem Batteriefach ausgeführt sein. Dadurch wird zumindest die Spannungs- beziehungsweise Stromversorgung der Bedienelemente oder die Spannungs- beziehungsweise Stromversorgung des gesamten elektronischen Messgerätes abgeschaltet, so dass das Auftreten eines Stromschlags sicher verhindert werden kann.

In vorteilhafter Weise lassen sich beim erfindungsgemäß vorgeschlagenen elektronischen Messgerät handelsübliche Alkaline-Batterien im AA-, AAA-Format oder eine 9 V-Batterie einsetzen. Ebenso gut ist als Stromquelle beispielsweise ein wiederaufladbarer Lithium-Ionen-Akkumulator oder ein Akkupack, bestehend aus mehreren wiederaufladbaren Akkumulatoren, einsetzbar. Somit ist hinsichtlich der einsetzbaren Stromquelle eine Dual-Use-Anwendung beim erfindungsgemäß vorgeschlagenen elektronischen Messgerät möglich. Des Weiteren kann durch die erfindungsgemäß vorgeschlagene Lösung in vorteilhafter Weise ein unsachgemäßes Hantieren an offenliegenden Stromquellen in Gestalt der Batterien verhindert werden, etwa dann, wenn diese bei im in das Batteriefach eingelegtem Zustand, jedoch bei offenem Batteriefachdeckel wieder aufgeladen werden. Eine derartige Gefahrensituation ist durch die Ausgestaltung des erfindungsgemäß vorgeschlagenen Messgeräts im Sinne der vorliegenden Erfindung sicher ausgeschlossen, so dass eine Bedienperson sicher vor einem Stromschlag und anderen Beeinträchtigungen geschützt ist.

### Kurze Beschreibung der Zeichnungen

Ausführungsformen der Erfindung werden anhand der Zeichnungen und der nachfolgenden Beschreibung näher erläutert.

Es zeigen:
- Figur 1: eine perspektivische Ansicht eines elektronischen Messgerätes,
- Figur 2: eine schematische Darstellung des erfindungsgemäß vorgeschlagenen elektronischen Messgerätes mit einem Batteriefachdeckel, der ein Betätigungselement aufweist,
- Figuren 3 und 3.1: Ansichten der Innenseiten des Gehäuses des elektronischen Messgerätes sowie des Batteriefachdeckels,
- Figuren 4 und 4.1: perspektivische Draufsichten auf einen Batteriefachdeckel und auf ein Batteriefach mit in dieses eingelegten Alkaline-Batterien sowie die Position des Trennschalters im Boden des Batteriefachs,
- Figur 5: eine schematische Darstellung des Trennschalters,
- Figur 6: einen Schnitt durch das Gehäuse des erfindungsgemäß vorgeschlagenen elektronischen Messgerätes und
- Figuren 7 und 7.1: eine Darstellung des Trennschalters in einer verkippten Lage und dessen Einbausituation im Inneren des Gehäuses des elektronischen Messgerätes bei geschlossenem Batteriefachdeckel.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

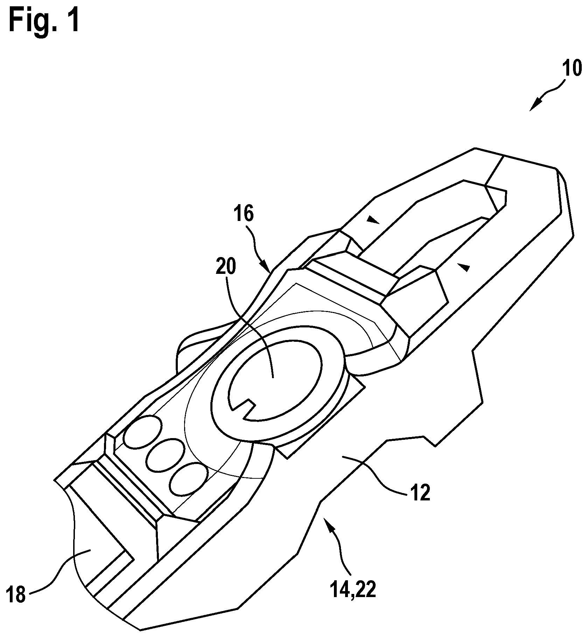

Der Darstellung gemäß Figur 1 ist ein elektronisches Messgerät 10 zu entnehmen, welches beispielsweise als Zangenamperemeter ausgebildet sein kann. Dieses umfasst ein Gehäuse 12, an dem hier nur schematisch dargestellte, relativ zueinander bewegbare Schenkel aufgenommen sind, die sich in der Darstellung gemäß Figur 1 in einer geschlossenen Position befinden. Auf einer Gehäusevorderseite 16 befindet sich ein verdrehbarer Wahlschalter 20, mit dem unterschiedliche Betriebsmodi des elektronischen Messgerätes 10 einstellbar sind. Auf der Gehäuserückseite 14 des Gehäuses 12 gemäß der Darstellung in Figur 1 ist ein in der folgenden Figurenbeschreibung näher beschriebenes Batteriefach 22 vorgesehen. Dieses nimmt entweder handelsübliche AA-, AAA- oder 9 V-Alkaline-Batterien oder einen wiederaufladbaren Lithium-Ionen-Akkumulator oder ein Akkupack oder dergleichen zum Betrieb des elektronischen Messgerätes 10 auf. Des Weiteren befindet sich auf der Gehäusevorderseite 16 ein in Figur 1 nur angedeutetes Display für den Bediener.

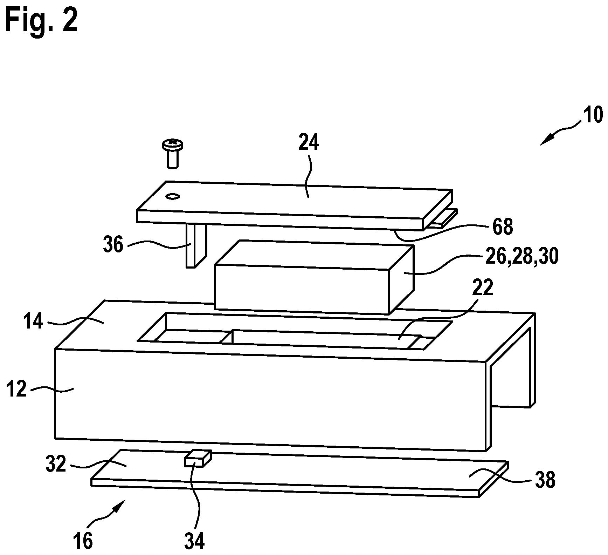

Der Darstellung gemäß Figur 2 ist in grober schematischer Vereinfachung ein elektronisches Messgerät 10 zu entnehmen, welches ein Gehäuse 12 umfasst. Auf einer Gehäuserückseite 14 befindet sich ein Batteriefach 22, während auf einer Gehäusevorderseite 16 ein hier nicht näher dargestelltes Display 18 sowie ein beispielsweise als Drehrad ausgebildeter Wahlschalter 20 zur Auswahl der Betriebsmodi des elektronischen Messgerätes 10 vorgesehen sein kann. Das Batteriefach 22 dient der Aufnahme einer Energiequelle 26 und nimmt handelsübliche Batterien 28, Akkumulatoren 30, einen Akkupack oder dergleichen auf.

In der als Explosionsdarstellung wiedergegebenen, stark vereinfachten Figur 2 wird in das Batteriefach 22 im Gehäuse 12 des elektronischen Messgerätes 10 eine Energiequelle 26 eingelassen. Dabei kann es sich um herkömmliche Alkaline-Batterien 28 (AA, AAA, 9 V-Alkaline-Batterien) handeln oder auch um einen wiederaufladbaren Lithium-Ionen-Akkumulator 30 oder einen Akkupack. Damit ist das elektronische Messgerät 10 für eine Dual-Use-Anwendung mit unterschiedlichen Energiequellen 26 geeignet. Wie aus der Darstellung gemäß Figur 2 hervorgeht, ist an einer Innenseite 68 eines Batteriefachdeckels 24 ein Betätigungselement 36 ausgebildet. Der Batteriefachdeckel 24 verschließt im aufgesteckten Zustand das Batteriefach 22. In der grob vereinfachten Ausführungsvariante gemäß Figur 2 ist das Betätigungselement 36 an der Innenseite 68 des Batteriefachdeckels 24 als rippenförmiger Vorsprung ausgeführt. Das Betätigungselement 36 kann auch als federnder Kontaktstift oder als balkenförmig, stift- oder stabförmig gestalteter Körper ausgebildet sein, der sich, ausgehend von der Innenseite 68 des Batteriefachdeckels 24, im Wesentlichen in vertikaler Richtung erstreckt. Wichtig ist, dass der Kopf des Betätigungselements 36 einen auf einer Oberseite 38 einer Leiterplattenanordnung 32 angeordneten Trennschalter 34 im montierten Zustand auf dem Batteriefach 22 kontaktiert. Der Trennschalter 34 ist derart ausgebildet, dass dieser bei Entnahme des Batteriefachdeckels 24 vom Batteriefach 22 das gesamte elektronische Messgerät 10
oder zumindest dessen Bedienelemente 18, 20 abschaltet.

Das Gehäuse 12 des elektronischen Messgerätes 10 gemäß der schematischen Darstellung in Figur 2 umfasst des Weiteren die bereits erwähnte Leiterplattenanordnung 32, auf deren Oberseite 38 der Trennschalter 34 aufgenommen ist. Der Trennschalter 34 kann im elektronischen Messgerät 10 so eingebaut sein, dass dieser entweder die komplette Strom- beziehungsweise Spannungsversorgung des elektronischen Messgerätes 10 oder zumindest die Spannungs- beziehungsweise Stromversorgung von dessen Bedienelementen, wie beispielsweise Display 18 oder als Drehrad ausgebildeter Wahlschalter 20, von der Spannungs- beziehungsweise Stromversorgung trennt.

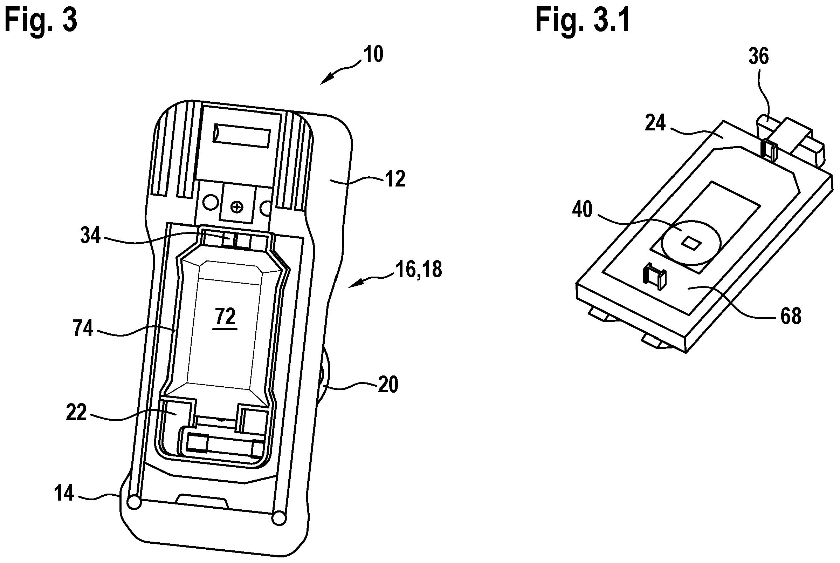

Den Figuren 3 und 3.1 ist zu entnehmen, dass bei entnommenem Batteriefachdeckel 24 das Batteriefach 22 freiliegt. Am Boden 72 des Batteriefachs 22 ist der Trennschalter 34 eingelassen. Auf der Gehäusevorderseite 16 gemäß der Darstellung in Figur 3 befinden sich hier nicht näher dargestellte Bedienelemente, wie beispielsweise ein Display 18 sowie ein beispielsweise als Drehrad ausgebildeter Wahlschalter 20, mit dessen Hilfe unterschiedliche Betriebsmodi des elektronischen Messgerätes 10 ausgewählt werden können. Das Batteriefach 22 weist eine umlaufende Batteriefachfassung 74 auf, die hinsichtlich ihrer Gestalt und Höhe komplementär zu einer ebenfalls umlaufenden Erhöhung an der Innenseite 68 des Batteriefachdeckels 24 ausgebildet ist. Am Batteriefachdeckel 24 befindet sich des Weiteren das besagte Betätigungselement 36, welches balken- oder stiftförmig ausgeführt sein kann und im montierten Zustand des Batteriefachdeckels 24 auf dem Batteriefach 22 besagten Trennschalter 34 betätigt und somit sicherstellt, dass nur bei geschlossenem Batteriefachdeckel 24 die Spannungs- beziehungsweise Stromversorgung des elektronischen Messgerätes 10 freigegeben ist. Auf der Innenseite 68 des Batteriefachdeckels 24 befindet sich ein Abstandhalter 40, der beispielsweise die Ausrichtung und Positionierung einer in den Figuren 3 und 3.1 nicht dargestellten Energiequelle 26 in Gestalt eines Lithium-Ionen-Akkumulators 30 oder eines Akkupacks im Batteriefach ausrichtet.

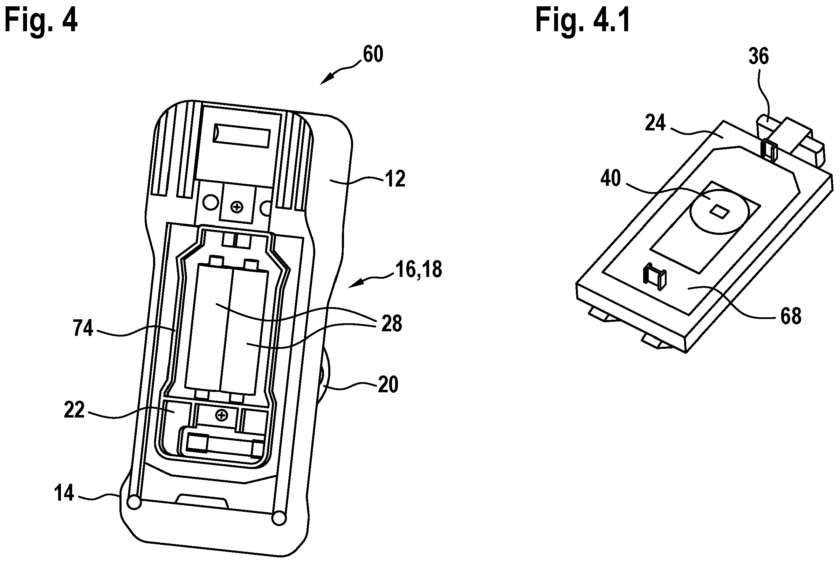

Den Figuren 4 und 4.1 ist zu entnehmen, dass anstelle eines wiederaufladbaren Lithium-Ionen-Akkumulators 30 oder eines Akkupacks als Energiequelle 26 auch handelsübliche Batterien 28, insbesondere Alkaline-Batterien eingesetzt werden können. Dazu bieten sich beispielsweise Batterien 28 der Größen AA, AAA oder 6 V-Alkaline-Batterien an. Diese werden, unterstützt durch den in Figur 4.1 an der Innenseite 68 des Batteriefachdeckels 24 dargestellten Abstandhalter 40, korrekt im Batteriefach 22 auf der Gehäuserückseite 14 des Gehäuses 12 des elektronischen Messgeräts 10 ausgerichtet und positioniert. Auch hier ist an der Gehäuseinnenseite 68 das Betätigungselement 36 zu erkennen, welches im montierten Zustand des Batteriefachdeckels 24 auf dem Batteriefach 22 den Trennschalter 34 betätigt, so dass nur im montierten Zustand des Batteriefachdeckels 24 auf dem Batteriefach 22 die Strom- oder Spannungsversorgung des elektronischen Messgerätes 10 beziehungsweise von dessen Bedienelementen, wie Display 18 und Wahlschalter 20, sichergestellt ist.

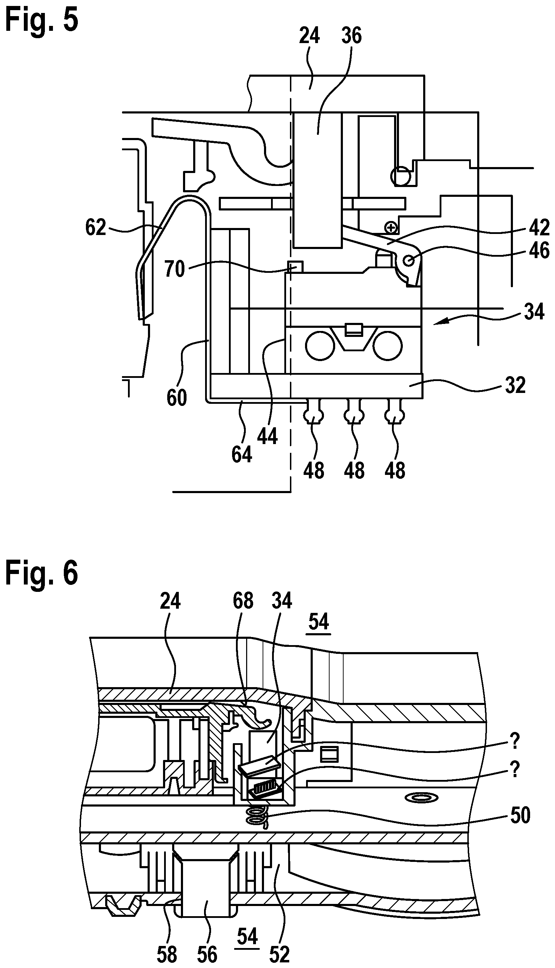

Der Darstellung gemäß Figur 5 ist in stark vereinfachter schematischer Darstellung die Ausbildung des Trennschalters 34 zu entnehmen. Dieser ist beispielsweise auf einer Oberseite 38 der Leiterplattenanordnung 32 vermittels eines Schaltkörpers 44 aufgenommen. Der Schaltkörper 44 des Trennschalters 34 weist auf seiner Oberseite einen um ein Gelenk 46 verschwenkbaren Schaltarm 42 auf. Unterhalb des Endes des gelenkig angeordneten Schaltarms 42 befindet sich auf der Oberseite des Schaltköpers 44 eine Kontaktstelle 70. Aus der schematischen Darstellung gemäß Figur 5 geht hervor, dass das an der Gehäuseinnenseite 68 des Batteriefachdeckels 24 ausgebildete stab- oder balkenförmig sich in vertikaler Richtung erstreckende Betätigungselement 36 den Schaltarm 42 um das Gelenk 46 auslenkt, bis dieses die Kontaktstelle 70 kontaktiert. Im kontaktierten Zustand der Kontaktstelle 70, d. h. bei auf dem Batteriefach 22 montiertem Batteriefachdeckel 24, ist demnach der Trennschalter 34 geschlossen und die Spannungs- beziehungsweise Stromversorgung des elektronischen Messgerätes 10 beziehungsweise von dessen Bedienelementen 18, 20 sichergestellt. An der Leiterplattenanordnung 32 gemäß der Darstellung in Figur 5 ist des Weiteren eine Kontaktfeder 60 vorgesehen, die eine elastisch ausgebildete Federzunge 62 umfasst. Die Kontaktfeder 60 ist entlang einer Federlasche 64 beispielsweise an der Unterseite der Leiterplattenanordnung 32 form- oder kraftschlüssig befestigt. Des Weiteren sind an der Unterseite der Leiterplattenanordnung 32 gemäß der Darstellung in Figur 5 eine Anzahl von Kontaktstiften 48 zu erkennen. An diesen wird die Leiterplattenanordnung 32 kontaktiert.

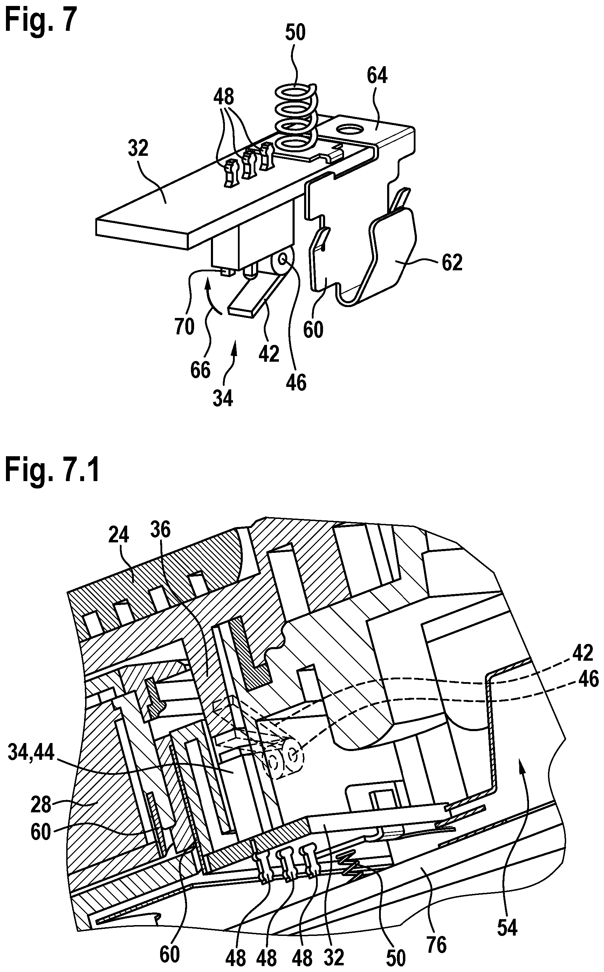

Figur 6 zeigt einen Schnitt durch das Gehäuse 12 des elektronischen Messgerätes 10, aus welchem hervorgeht, dass die Leiterplattenanordnung 32 vermittels einer Anstellfeder 50 an eine Gehäuserippe 76 (vgl. Figur 7.1) angestellt ist. Mittels des Betätigungselements 36 wird, wie im Zusammenhang mit Figur 5 bereits beschrieben, der Trennschalter 34 geschlossen, sobald das Betätigungselement 36 bei auf dem Batteriefach 22 montiertem Batteriefachdeckel 24 den Schaltarm 42 derart auslenkt, dass dieser die Kontaktstelle 70 des Schaltkörpers 44 berührt.

Aus Figur 6 geht des Weiteren hervor, dass ein Betätigungselement 56 in eine Gehäusewandöffnung 58 eingelassen ist. Dieses Betätigungselement 56 kann beispielsweise seitlich am elektronischen Messgerät 10 angeordnet sein.

Den Figuren 7 und 7.1 ist zu entnehmen, dass die in Figur 7 in einer Kopfüberlage dargestellte Leiterplattenanordnung 32 den Schaltkörper 44 des Trennschalters 34 aufnimmt. Um das hier nur schematisch dargestellte Gelenk 46 ist der Schaltarm 42 bewegbar, der bei entsprechender Betätigung durch das Betätigungselement 36 an der Innenseite 68 des Batteriefachdeckels 24 entsprechend einer Auslenkung 66 die auf dem Schaltkörper 44 vorgesehene Kontaktstelle 70 kontaktiert. Des Weiteren ist der Kopfüberdarstellung gemäß Figur 7 zu entnehmen, dass die Kontaktfeder 60 mit ihrer Federlasche 64 an der Unterseite der Leiterplattenanordnung 32, d. h. an der Seite der Leiterplattenanordnung 32, an der sich die Kontaktstifte 48 befinden, befestigt ist. Die Kontaktfeder 60 umfasst des Weiteren eine elastisch ausgebildete Federzunge 62. Bevorzugt wird die Kontaktfeder 60 als ein Stanz- und Biegeteil aus metallischem Material ausgebildet. Des Weiteren ist der Darstellung gemäß Figur 7 zu entnehmen, dass die Leiterplattenanordnung 32 von der Unterseite her - wie in Figur 6 dargestellt - mittels der Anstellfeder 50 an eine Gehäuserippe beziehungsweise einen Gehäusevorsprung 76 des Gehäuses 12 des elektronischen Messgerätes 10 angestellt ist.

Figur 7.1 zeigt die montierte Position der Anordnung gemäß Figur 7 innerhalb des Innenraums 52 des Gehäuses 12 des elektronischen Messgerätes 10. Auch hier ist erkennbar, dass die Leiterplattenanordnung 32 durch die Anstellfeder 50 gegen eine Gehäuserippe beziehungsweise einen Gehäusevorsprung 76 gedrängt wird. Der in Figur 7.1 dargestellte Schaltarm 42, der am Gelenk 46 des Schaltkörpers 44 angelenkt ist, wird durch das sich im Wesentlichen in vertikaler Richtung erstreckende Betätigungselement 36 gegen die Kontaktstifte 48 auf der Oberseite des Schaltkörpers 44 gedrückt. Dies erfolgt nur dann, wenn der Batteriefachdeckel 24 - wie in Figur 7.1 dargestellt - auf dem Batteriefach 22 montiert ist und der Trennschalter 34 geschlossen ist, wodurch die Strom- beziehungsweise Spannungsversorgung der elektrischen beziehungsweise elektronischen Komponenten des elektronischen Messgerätes 10 freigegeben ist.

Aus der perspektivischen Ansicht gemäß Figur 7.1 geht zudem hervor, dass sich an der Unterseite der Leiterplattenanordnung 32 die Kontaktstifte 48 in den Innenraum 52 des Gehäuses 12 des elektronischen Messgeräts 10 erstrecken, so dass die Kontaktierung der Leiterplattenanordnung 32 sichergestellt ist.

Durch die erfindungsgemäß vorgeschlagene Lösung ist die Strom- beziehungsweise Spannungsversorgung des elektronischen Messgerätes 10 beziehungsweise von dessen Bedienelementen wie Display 18 und Wahlschalter 20 nur dann sichergestellt, wenn sich der Batteriefachdeckel 24 im auf dem Batteriefach 22 montierten Zustand befindet. Nur in diesem Fall ist durch das Betätigungselement 36 an der Innenseite 68 des Batteriefachdeckels 24 sichergestellt, dass der Trennschalter 34 im Boden 72 des Batteriefachs 22 kontaktiert ist und der Trennschalter 34 geschlossen ist. Sobald der Batteriefachdeckel 24 entfernt wird, öffnet sich der Trennschalter 34 durch Wegfall des Betätigungselements 36 und unterbricht die Spannungs- beziehungsweise Stromversorgung des elektronischen Messgerätes 10 als Ganzes oder zumindest von dessen Bedienelementen, wie Display 18 und Wahlschalter 20.

Das elektronische Messgerät 10 gemäß den vorstehend beschriebenen Figuren kann beispielsweise als Multimeter, als Zangenamperemeter, als Gabelamperemeter oder als Spannungsmesser ausgebildet sein und zur kontaktlosen oder kontaktbehafteten Messung elektrischer Größen, wie beispielsweise Ströme, Spannungen, Widerstände, Kapazitäten, Temperaturen, Impedanzen und dergleichen in Gleich- oder Wechselstromanwendungen eingesetzt werden. Des Weiteren ist das erfindungsgemäß vorgeschlagene elektronische Messgerät 10 für einen Dual-Use geeignet, d. h. bei der in diesem eingesetzten Energiequelle 26 kann es sich sowohl um herkömmliche Batterien 28 (Alkaline-Batterien) als auch um einen wiederaufladbaren Lithium-Ionen-Akkumulator 30 oder ein Akkupack handeln.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Elektronisches Messgerät (10) zur Messung elektrischer Größen, insbesondere Spannung, Strom und/oder elektrischer Widerstand, mit einem Gehäuse (12), in dem ein Batteriefach (22) zur Aufnahme einer Energiequelle (26) ausgebildet ist, welches über einen entnehmbaren Batteriefachdeckel (24) zugänglich ist, **dadurch gekennzeichnet, dass** das Batteriefach (22) mit einem Trennschalter (34) versehen ist, der bei Entnahme des Batteriefachdeckels (24) vom Batteriefach (22) das gesamte elektronische Messgerät (10) oder zumindest dessen Bedienelemente (18, 20) abschaltet.

2. Elektronisches Messgerät (10) gemäß Anspruch 1, **dadurch gekennzeichnet, dass** der Batteriefachdeckel (24) an einer Innenseite (68) ein Betätigungselement (36) aufweist, welches im auf dem Batteriefach (22) montierten Zustand des Batteriefachdeckels (24) den Trennschalter (34) betätigt.

3. Elektronisches Messgerät (10) gemäß den Ansprüchen 1 bis 2, **dadurch gekennzeichnet, dass** der Trennschalter (34) in das Gehäuse (12), insbesondere in einen Boden (72) des Batteriefachs (22) eingelassen ist.

4. Elektronisches Messgerät (10) gemäß den Ansprüchen 1 bis 3, **dadurch gekennzeichnet, dass** der Trennschalter (34) einen einseitig an einem Schaltkörper (44) angelenkten Schaltarm (42) aufweist.

5. Elektronisches Messgerät (10) gemäß den Ansprüchen 1 bis 4, **dadurch gekennzeichnet, dass** der Trennschalter (34) auf einer Oberseite (38) einer Leiterplattenanordnung (32) aufgenommen ist.

6. Elektronisches Messgerät (10) gemäß den Ansprüchen 1 bis 5, **dadurch gekennzeichnet, dass** die Leiterplattenanordnung (32) im Innenraum (52) des Gehäuses (12) im Wesentlichen auf dem Niveau des Bodens (72) des Batteriefachs (22) liegt und mittels einer Anstellfeder (50) an eine Gehäuserippe (76) des Gehäuses (12) angestellt ist.

7. Elektronisches Messgerät (10) gemäß den Ansprüchen 1 bis 6, **dadurch gekennzeichnet, dass** bei montiertem Batteriefachdeckel (24) dessen Betätigungselement (36) den Schaltarm (42) des Trennschalters (34) an eine Kontaktstelle (70) des Schaltkörpers (44) anstellt und eine Strom-/Spannungsversorgung des elektrischen Messgerätes (10) freigibt.

8. Elektronisches Messgerät (10) gemäß den Ansprüchen 1 bis 7, **dadurch gekennzeichnet, dass** das Betätigungselement (36) an der Innenseite (68) des Batteriefachdeckels (24) im Wesentlichen stab- oder stiftförmig ausgebildet ist.

9. Elektronisches Messgerät (10) gemäß den Ansprüchen 1 bis 8, **dadurch gekennzeichnet, dass** das Betätigungselement (36) als federnder Kontaktstift (48) ausgeführt ist.

10. Elektronisches Messgerät (10) gemäß einem der Ansprüche 1 bis 9, **dadurch gekennzeichnet, dass** dieses als Multimeter, als Zangenamperemeter, als Gabelamperemeter oder als Spannungsmesser ausgeführt ist, zur Messung elektrischer Größen, insbesondere Ströme, Spannungen, elektrische Widerstände, Kapazitäten, Temperaturen, Impedanzen in Gleichstrom- oder Wechselstromanwendungen.
